# FASCICULE DE BREVET EUROPEEN

(11) **EP 1 670 997 B1**
(45) Date de publication et mention de la délivrance du brevet: **20.05.2020**
(21) Numéro de dépôt: 04787494.6
(22) Date de dépôt: 30.09.2004
(51) Int. Cl.: E04B 1/80, D04H 13/00, B32B 5/26, B32B 5/28

(54) **PANNEAU ISOLANT A BASE DE FIBRE MINERALE, PROCEDE POUR SA PRODUCTION ET SON UTILISATION**
DÄMMPANEL AUF MINERALFASERBASIS UND HERSTELLUNGSMETHODE
MINERAL FIBRE-BASED INSULATING PANEL, PRODUCTION METHOD THEREOF AND USE OF SAME

(30) Priorité: 30.09.2003 IT MI20031877
(43) Date de publication de la demande: 21.06.2006
(73) Titulaire: SAINT-GOBAIN ISOVER, 92400 Courbevoie (FR)
(72) Inventeur: FERRI, Enrico, 24047 Treviglio BG (IT); MAZZOLENI, Sergio, 24124 Bergamo BG (IT); VALOTA, Franco, 24050 Bariano BG (IT)
(74) Mandataire: Saint-Gobain Recherche
(86) Numéro de dépôt international: PCT/FR2004/002487
(87) Numéro de publication internationale: WO 2005/032811

(56) Documents cités:
- EP-A- 0 476 176
- EP-A- 0 585 626
- US-A- 5 281 470
- US-A- 5 503 893

## Description

La présente invention concerne un panneau isolant à base de fibres minérales choisies parmi les fibres de verre, la laine de verre ou la laine de roche, et un procédé de production d'un tel panneau isolant. Dans un souci de simplicité, dans ce qui suit, on parlera principalement de panneaux de fibres de verre.

Des panneaux d'isolation thermique qui sont généralement utilisés pour calorifuger des appareils électriques notamment ménagers, par exemple des fours de cuisine, électriques ou à micro-ondes, des réfrigérateurs, des chaudières, des conditionneurs ou climatiseurs et similaires, sont largement diffusés sur le marché.

De tels panneaux prévoient une âme en matériau isolant, par exemple des fibres de verre, qui est éventuellement revêtue sur une face ou sur les deux faces par un film d'aluminium. La couche de revêtement en aluminium est appliquée pour améliorer la manipulation des panneaux, pour retenir les poussières créées par les fibres de verre, pour réduire les risques d'effilochage des fibres de verre et leur collage lorsque les panneaux sont superposés ou empilés.

Ces panneaux sont en général placés à l'extérieur de l'ouverture de l'appareil électroménager, le revêtement d'aluminium du panneau étant généralement disposé sur la face du panneau qui est tournée vers l'extérieur de l'appareil électroménager. En général, ces panneaux ne sont pas visibles et sont placés dans un interstice formé dans le caisson de l'appareil électroménager.

Le document EP 0 476 176 A1 décrit un tel panneau d'isolation thermique à base de fibres minérales.

En général, avant d'être assemblés sur l'appareil électroménager, ces panneaux sont préformés avec des trous qui conviennent pour accueillir des moyens de fixation et pour permettre par exemple le passage des câbles électriques de l'appareil électroménager.

Les panneaux isolants de la technique connue présentent différents inconvénients, qui sont dus surtout aux caractéristiques de conductivité électrique et thermique de la couche de revêtement en aluminium.

En effet, comme ces panneaux sont souvent traversés par des câbles électriques sont en contact avec eux, si ces câbles électriques ne sont pas isolés de façon adéquate, le revêtement d'aluminium, qui est électriquement conducteur, risque de créer des courts-circuits dangereux. Le revêtement d'aluminium n'est de plus pas suffisamment élastique et donc flexible et est de plus susceptible de se rompre, en plus de risque de se couper sur les bords.

En outre, comme l'âme en fibres de verre est un bon isolant thermique, alors que le revêtement d'aluminium est un bon conducteur de la chaleur, il se crée entre l'âme de fibres de verre et le revêtement d'aluminium un pont thermique qui compromet les caractéristiques isolantes du panneau.

Pour la production de ces panneaux dans la technique connue, on introduit d'abord du verre fondu dans une machine de production de fibres de laquelle sortent des fibres de verre qui sont mélangées avec le liant et tombent sur une bande transporteuse sur laquelle elles subissent une aspiration d'air pour ensuite être transportées dans un four pour stabiliser le liant.

Dans une variante à l'utilisation d'un liant, pour relier les fibres de verre de l'âme du panneau, ces fibres de verre rassemblées sur la bande transporteuse peuvent subir une opération d'aiguilletage pour obtenir un lien mécanique par recours à des aiguilles spéciales à crochet.

En tout cas, on obtient une âme ou tapis de fibres de verre reliées entre elles, par des moyens chimiques (à l'aide d'un liant) ou par des moyens mécaniques (par aiguilletage), qui est éventuellement enroulé en rouleau pour être transporté vers une phase ultérieure de travail dans laquelle les revêtements d'aluminium sont collés sur le matelas de fibres de verre au moyen d'un adhésif approprié au silicate.

Ensuite, le tapis de fibres de verre avec son revêtement d'aluminium est enroulé en rouleaux ou éventuellement taillé pour la formation de panneaux semi-finis qui sont découpés de manière à obtenir les dimensions voulues avec des trous avantageux de fixation et de passage des câbles.

Enfin, les rouleaux ou les panneaux du produit semi-fini sont envoyés dans une phase de séchage final, pour faire sécher l'adhésif utilisé pour l'application du revêtement d'aluminium.

Il apparaît à l'évidence que ces procédés de production de panneaux isolants sont longs et coûteux, surtout à cause de la multiplicité des phases nécessaires pour le collage du revêtement d'aluminium.

L'objet de la présente invention est d'éliminer les inconvénients de la technique connue en proposant un panneau isolant à base de fibres de verre qui ait de bonnes caractéristiques de calorifugeage et en même temps assure une bonne isolation électrique.

Un autre objet de l'invention est de proposer un panneau isolant qui soit extrêmement flexible et qui élimine tout risque de se couper.

Encore un autre objet de la présente invention est de proposer un tel panneau isolant qui soit versatile, pratique pour l'utilisateur, économique et de réalisation simple.

Selon l'invention, ces objets sont atteints avec le panneau isolant qui présente les caractéristiques reprises dans la revendication indépendante 1 annexée.

Un autre objet de la présente invention est de proposer un procédé de production d'un panneau isolant à base de fibres minérales qui soit efficace, rapide et en même temps économique et simple.

Selon l'invention, cet objet est atteint avec les procédés de production d'un panneau isolant dont les phases sont reprises respectivement dans les revendications 12 et 18 annexées.

L'invention a enfin pour objet l'utilisation d'un tel panneau isolant dans un appareil électrique, en particulier électroménager, tel que ceux mentionnés précédemment.

Le panneau isolant à base de fibres de verre selon l'invention comprend une âme de fibres de verre liées entre elles et une couche de revêtement reliée à au moins une face de l'âme de fibres de verre.

La caractéristique particulière de l'invention consiste en le fait que la couche de revêtement comprend un tissu non-tissé (TNT), un tissu de fibres minérales ou un voile de fibres minérales, en particulier de fibres de verre. Par commodité, dans ce qui suit, la couche de revêtement sera désignée principalement comme couche de tissu non-tissé (TNT), aussi communément appelé « non-tissé ».

Elle permet d'obtenir de nombreux avantages, tant dans le produit final que dans le procédé de production.

En effet, le non-tissé est un bon isolant, tant électrique que thermique. Le résultat en est que l'on élimine les risques de court-circuit des câbles électriques qui traversent le panneau et en même temps, on ne constate pas de brusques sauts thermiques entre l'âme de laine de verre et la couche de revêtement en non-tissé.

En outre, le revêtement en TNT améliore les manipulations du panneau en garantissant une meilleure sensation au toucher par l'utilisateur que les panneaux dotés d'un revêtement d'aluminium.

En outre, comme le TNT est plus élastique et flexible que l'aluminium, en plus d'améliorer les manipulations du panneau, on évite les risques de rupture des bords du panneau.

D'autres caractéristiques de l'invention apparaîtront plus clairement à la lecture de la description détaillée qui suit, qui concerne de manière purement exemplative et donc non limitative ses modes de réalisation représentés dans les dessins annexés, dans lesquels:
la figure 1 est un organigramme qui représente schématiquement le procédé de production d'un panneau isolant à base de fibres minérales selon l'invention et
la figure 2 est un organigramme qui représente schématiquement un deuxième mode de réalisation du procédé de production d'un panneau isolant à base de fibres minérales.

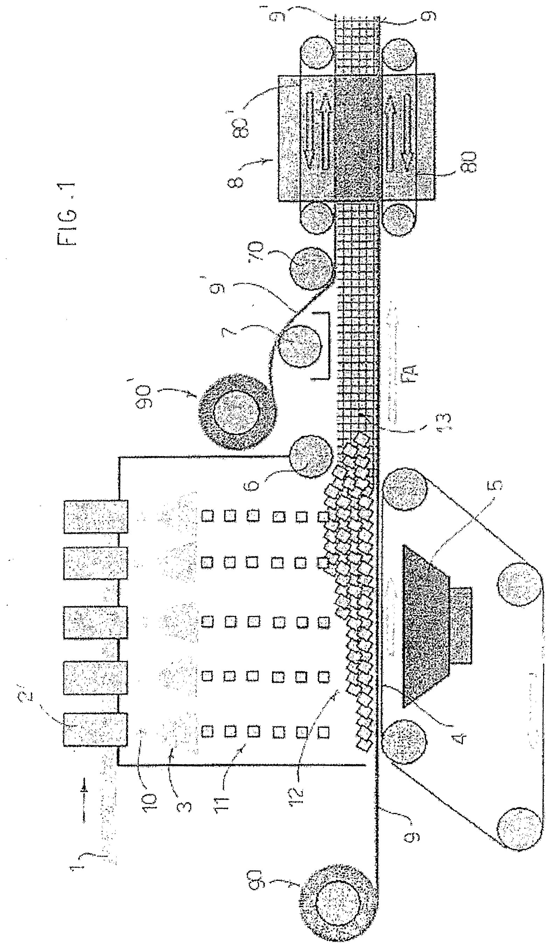

A l'aide de la figure 1, décrivons maintenant un premier mode de réalisation du procédé de production du panneau isolant à base de fibres de verre selon l'invention.

Une pâte de verre fondu 1 est envoyée dans une machine de production de fibres 2 qui produit une pluralité de fibres de verre 10.

La machine met en œuvre un procédé de fibrage rotatif dit à centrifugation interne, dans lequel la matière fondue est reçue dans un organe rotatif à symétrie de révolution nommé assiette, présentant une paroi percée d'une pluralité d'orifices à travers lesquelles la matière fondue est éjectée et prise en charge par un courant gazeux d'étirage.

Aux fins de la présente invention, la machine est réglée pour produire des fibres caractérisée par un micronaire de l'ordre de 3 à 4,5 sous 5g.
Suivant la réalisation de la figure 1, les fibres ont avantageusement un micronaire de l'ordre de 3 à 3,8 sous 5g.

Les fibres de verre 10 qui sortent de la machine 2 de production de fibres sont transportées au travers d'une couronne de pulvérisation 3 dans laquelle on pulvérise un ou des liants qui se combinent avec les fibres de verre 10 dans le but de favoriser une liaison chimique entre elles. Parmi les liants, on peut utiliser des liants minéraux tels que, par exemple une solution aqueuse de sels de polyphosphate d'aluminium.

De cette manière, des fibres de verre mêlées aux liants 11 sortent de la machine de pulvérisation 3 et sont rassemblées sur un support 9 de manière à former une masse peu compacte 12 de fibres de verre et de liant dans laquelle le liant exerce son action de liaison sur les fibres de verre. Le support 9 a la forme d'un ruban qui est déroulé d'une bobine-mère 90 et que l'on fait avanqer dans le sens de la flèche F_{A} au moyen d'un transporteur 4.

Le support 9 est une bande réalisée en tissu non-tissé (TNT), en tissu de verre ou en voile de verre. Le support 9 est de préférence composé d'un non-tissé à base de matière plastique, par exemple des dérivés de polyéthylène et/ou de polyester, auxquels sont éventuellement ajoutés des charges d'oxydes métalliques.

Dans la zone du transporteur 4, en dessous du support 9 est disposé un aspirateur 5 qui a pour fonction d'aspirer l'air de la masse peu compacte 12 de fibres de verre et de liant à travers le support 9 de manière à aspirer les poussières des fibres de verre et en même temps à favoriser une première réduction de l'humidité des fibres et des liants.

Il faut remarquer que grâce au fait que l'on utilise un support 9 en tissé-non-tissé à un grammage qui permet de filtrer l'air, on peut exécuter la phase d'aspiration de l'air en même temps que la réception de la masse de fibres de verre 12 sur le support 9. Cette opération est clairement impossible si comme support 9 on utilise un matériau métallique, par exemple un film d'aluminium, comme dans la technique connue, qui ne permet pas le passage de l'air. Un grammage de l'ordre de 10 à 100 g/m² remplit efficacement la fonction de permettre l'aspiration d'air.

En aval de l'aspirateur 5, mais aussi de la masse de fibres de verre 12, est placé un rouleau presseur 6 qui a pour fonction de réaliser un premier compactage des fibres de verre de manière à obtenir une âme ou un tapis; de fibres de verre 13 essentiellement homogènes disposés sur le support 9. L'adhérence du support inférieur 9 au tapis de fibres de verre 13 est garantie par la phase d'aspiration effectuée par l'aspirateur 5, pendant laquelle l'humidité du liant est diminuée.

Si comme produit final, on souhaite un panneau de fibres de verre qui est doté d'un revêtement sur les deux faces, on utilise une deuxième bobine-mère 90' de laquelle on déroule une bande de TNT 9' avantageusement essentiellement identique au revêtement 9 déroulé par la première bobine-mère 90.

En aval du rouleau presseur 6, au-dessus du tapis de fibres de verre compactées 13, est placé un groupe "encreur" 7 qui comprend un rouleau distributeur de liant qui reprend le liant dans une cuve située par-dessous et l'étend sur la surface inférieure de la bande de TNT 9'. Le liant utilisé dans cette phase peut être le même liant que celui utilisé dans la machine de pulvérisation 3 dans d'autres solutions aqueuses, ou être un liant minéral différent.

La nécessité d'utiliser le groupe encreur 7 est due au fait qu'en aval de l'aspirateur 5, le liant ajouté aux fibres de verre pendant la phase de pulvérisation est en général trop asséché voire complètement séché et ne convient donc pas en général pour garantir la prise du support supérieur sur le tapis de fibres de verre 13.

En aval du groupe encreur 7 est prévu un rouleau presseur 70 qui détermine l'accouplement du support 9' et du tapis de fibres 13. A ce stade l'âme de fibres minérales a généralement une épaisseur de l'ordre de 15 à 35 mm, notamment de l'ordre de 20 à 30 mm.

Pour permettre l'adhérence du support supérieur 9' sur le tapis de fibres de verre 13, le tapis de fibres de verre 13 comprimé en sandwich entre le support inférieur 9 et le support supérieur 9' est avancé au moyen d'une bande transporteuse inférieure 80 et d'une bande transporteuse supérieure 80' dans un four 8 qui provoque le séchage du liant déposé par le groupe encreur 7 et par conséquent l'adhérence du support supérieur 9' sur le tapis de fibres de verre 13 et la stabilisation de l'adhésif entre les fibres. La température de fonctionnement du four 8 de séchage du liant est comprise dans l'intervalle de 100°C à 200°C.

Enfin, la couche de fibres de verre 13 à laquelle sont liés le support inférieur et le support supérieur 9, 9' est reprise en un rouleau ou est taillée et découpée directement de manière à obtenir des feutres isolants de dimensions appropriées, constitués d'une couche de fibres de verre 13 liées entre elles et liées à au moins un support 9, 9' au moyen de liants de type minéral.

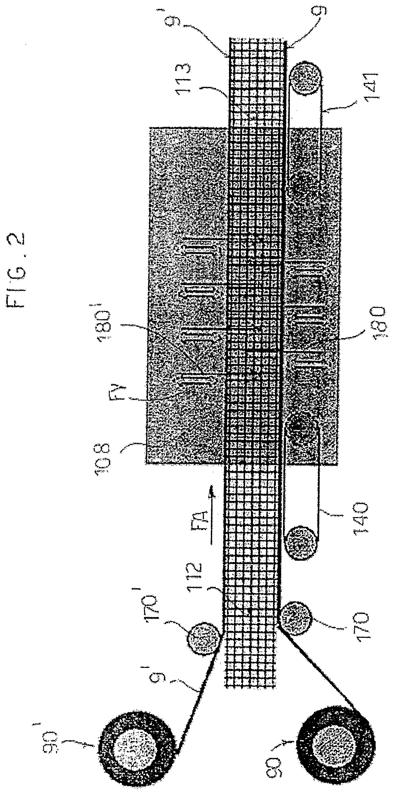

En référence à la figure 2, décrivons un deuxième mode de réalisation des procédés de production d'un panneau isolant à base de fibres de verre configurés comme variantes du procédé de la figure 1. Par conséquent, dans ce deuxième mode de réalisation, des éléments identiques correspondants à ceux que l'on a déjà décrits en référence à la figure 1 sont désignés par les mêmes références numériques et on omettra leur description détaillée.

Dans ce deuxième mode de réalisation, les fibres de verre 10 sortent de la machine 2 de production de fibres ne sont pas mélangées avec des liants aptes à créer une liaison chimique entre les fibres. Dans ce cas, on utilise une quantité minime d'agents qui ont pour seul but de retenir la poussière et non de créer une liaison chimique entre les fibres. Généralement, comme additifs anti-poussière, on utilise un type d'agent connu en soi dénommé Fomblin®.

Suivant la réalisation de la figure 2, les fibres ont avantageusement un micronaire de l'ordre de 3,5 à 4,5 sous 5g.

A ce point, les fibres de verre sont rassemblées de manière former un tapis 112 (figure 2) qui peut être enroulé en un rouleau.

Le tapis de fibres de verre 112 est avancé entre deux supports 9, 9' déroulés d'une première et d'une deuxième bobine-mère 90, 90'. Il est clair que si l'on souhaite le revêtement sur une seule face des fibres, l'une des deux bobines 90, 90', de préférence la bobine supérieure 90', peut être omise.

En aval des bobines 90, 90', des rouleaux respectifs d'accouplement 170, 170' aptes à tendre les supports 9, 9' respectifs sont prévus en dessous et au-dessus du tapis de fibres de verre 112. Le tapis de fibres de verre 112 avec les supports 9, 9' respectifs est avancé au moyen d'un transporteur 140 dans la direction de la flèche F_{A} vers une machine d'aiguilletage 108.

La machine d'aiguilletage 108 comprend une pluralité d'aiguilles à crochet 180 disposées en dessous du plan du support inférieur 9, et une pluralité d'aiguilles à crochet 180' disposées au-dessus du plan du support supérieur 9'. Les aiguilles inférieures 180 et les aiguilles supérieures 180' se déplacent verticalement dans un déplacement alterné dans le sens des flèches F_{V}.

De cette manière, les aiguilles 180, 180' traversent les supports 9, 9' respectifs et lient les fibres de verre du tapis 112 entre elles et aux supports 9, 9' respectifs. Comme résultat, à la sortie de la machine d'aiguilletage 108, on aura un tapis ou une âme de fibres de verre compactes 113 dans laquelle les fibres de verre sont liées mécaniquement entre elles, au support inférieur et au support supérieur respectifs 9, 9' .

Il faut remarquer que grâce au fait que l'on utilise un support 9, 9' en non-tissé d'un grammage qui convient pour permettre la traversée des aiguilles 180, 180', de 10 à 100 g/m², on peut exécuter la phase d'aiguilletage directement sur les supports 9, 9' en évitant de cette manière la phase ultérieure de collage des supports 9, 9' sur le tapis de fibres 112. Cette opération qui est clairement impossible si on utilise comme supports 9, 9' un matériau métallique, par exemple un film d'aluminium, comme dans la technique connue, qui serait perforée par le passage des aiguilles 180, 180' sans pour autant créer de liaison entre le film et l'âme de fibres.

Un tel tapis de fibres 113 avec ses supports 9, 9' respectifs liés mécaniquement est transporté hors de la machine d'aiguilletage 108 au moyen d'un transporteur 141 et de là envoyé aux phases ultérieures d'enroulement en rouleaux et ensuite de découpe et/ou de taille, de manière à obtenir les produits voulus.

Aux présents modes de réalisation de l'invention, on peut apporter de nombreuses variations et modifications de détails à la portée d'un homme du métier, qui sont cependant comprises dans la portée de l'invention qui est définie par les revendications annexées.

## Revendications

1. Panneau isolant pour calorifugeage d'appareil électrique, le panneau étant à base de fibres minérales choisies parmi les fibres de verre, la laine de verre ou la laine de roche, et comprenant une âme (13; 113) de fibres minérales liées entre elles par un liant minéral ou par un lien mécanique et une couche de revêtement (9, 9') appliquée sur au moins une face de ladite âme de fibres minérales (13; 113), **caractérisé en ce que** ladite couche de revêtement (9; 9') comprend un tissu non-tissé (TNT), un tissu de fibres minérales ou un voile de fibres minérales, **en ce que** la couche de revêtement est liée chimiquement aux fibres minérales de l'âme par un liant minéral ou liée mécaniquement aux fibres minérales de l'âme et **en ce que** ladite couche de revêtement (9; 9') présente un grammage compris dans l'intervalle de 10 g/m² à 100 g/m².

2. Panneau selon la revendication 1, **caractérisé en ce que** ladite couche de revêtement (9; 9') comprend un tissu ou un voile de fibres de verre.

3. Panneau selon la revendication 1, **caractérisé en ce que** ladite couche de revêtement (9; 9') comprend un tissu non-tissé (TNT) de fibres synthétiques polymères, notamment constitué de dérivés de polyéthylène et de polyester auxquels sont éventuellement ajoutés des charges d'oxydes métalliques.

4. Panneau selon l'une quelconque des revendications précédentes, **caractérisé en ce que** ladite couche de revêtement (9; 9') a une épaisseur comprise de manière indicative dans l'intervalle de 0,05 mm à 1,5 mm.

5. Panneau selon l'une quelconque des revendications précédentes, **caractérisé en ce que** l'âme de fibres minérales présente une masse surfacique de l'ordre de 600 à 1000 g/m².

6. Panneau selon l'une quelconque des revendications précédentes, **caractérisé en ce que** l'âme de fibres minérales comprend des fibres de verre d'un micronaire de l'ordre de 3 à 4,5 sous 5g.

7. Panneau selon l'une quelconque des revendications précédentes, **caractérisé en ce qu'**il comprend des liants chimiques pour permettre à la fois une liaison chimique entre les fibres minérales de l'âme (13) et une liaison chimique entre la couche de revêtement (9; 9') et les fibres minérales de l'âme (13).

8. Panneau selon la revendication 7, **caractérisé en ce que** ledit liant chimique est un liant minéral constitué d'une solution aqueuse de sels de polyphosphate d'aluminium.

9. Panneau selon l'une quelconque des revendications 1 à 6, **caractérisé en ce que** lesdites fibres minérales de l'âme (113) sont liées entre elles mécaniquement et **en ce que** ladite couche de revêtement (9, 9') est liée mécaniquement aux fibres minérales de l'âme (113).

10. Panneau selon la revendication 9, **caractérisé en ce que** ladite liaison mécanique est obtenue par aiguilletage des fibres minérales entre elles et par aiguilletage des fibres minérales à la couche de revêtement (9, 9').

11. Panneau selon la revendication 9 ou 10, **caractérisé en ce qu'**il comprend un agent anti-poussière entre les fibres minérales de l'âme (113.

12. Procédé pour la production d'un panneau isolant à base de fibres minérales selon l'une quelconque des revendications 1 à 8, et qui comprend les étapes ci-dessous:
- filage des fibres minérales (10) à partir d'une substance minérale fondue (1),
- liaison de type chimique entre lesdites fibres minérales (10) de manière à obtenir une âme de fibres minérales (13; 113) liées chimiquement entre elles,
- liaison de type chimique de ladite âme de fibres minérales (13; 113) à une couche de revêtement (9, 9') disposée sur au moins une face de ladite âme de fibres minérales (13; 113).

13. Procédé selon la revendication 12, **caractérisé en ce que** ladite phase de liaison des fibres minérales (13; 113) entre elles s'effectue en même temps que l'étape de liaison des fibres minérales à la couche de revêtement (9, 9'), par recours à une liaison de type chimique.

14. Procédé selon les revendications 12 ou 13, **caractérisé en ce que** lesdites étapes de liaison de type chimique comprennent les phases suivantes:
- addition d'un liant minéral aux fibres minérales (10),
- réception des fibres minérales (11) avec le liant minéral sur une bande de ladite couche de revêtement (9),
- aspiration de l'air à travers ladite couche de revêtement (9) et ensuite séchage desdits liants minéraux pour créer la liaison de fibres minérales entre elles et la liaison des fibres minérales à la couche de revêtement (9).

15. Procédé selon la revendication 14, **caractérisé en ce qu'**il comprend en outre les étapes qui consistent à:
- déposer le liant minéral sur une deuxième couche de revêtement (9') et
- appliquer ladite deuxième couche de revêtement (9') sur la surface de l'âme de fibres minérales (13) qui est opposée à celle à laquelle est liée ladite première couche de revêtement (9), de telle sorte que ledit liant minéral se trouve entre ladite deuxième couche de revêtement (9') et une face de l'âme de fibres minérales (13).

16. Procédé selon la revendication 15, **caractérisé en ce qu'**il comprend en outre l'étape de séchage dudit liant minéral déposé entre ladite deuxième couche de revêtement (9') et une surface de l'âme de fibres minérales (13), par réchauffement.

17. Procédé selon la revendication 16, **caractérisé en ce que** ladite étape de séchage du liant minéral par réchauffement s'effectue à une température comprise dans l'intervalle de 100°C à 200°C.

18. Procédé de production d'un panneau isolant à base de fibres minérales selon l'une quelconque des revendications 9 à 11, qui comprend les étapes suivantes:
- filage des fibres minérales (10) à partir d'une substance minérale fondue (1),
- liaison de type mécanique desdites fibres minérales (10) entre elles de manière à obtenir une âme de fibres minérales (113) liées mécaniquement entre elles,
- liaison de type mécanique de ladite âme de fibres minérales (113) à une couche de revêtement (9, 9') disposée sur au moins une face de ladite âme de fibres minérales (113).

19. Procédé selon la revendication 18, **caractérisé en ce que** ladite étape de liaison de fibres minérales (113) entre elles s'effectue en même temps que l'étape de liaison des fibres minérales à la couche de revêtement (9, 9'), par une liaison de type mécanique.

20. Procédé selon les revendications 18 ou 19, **caractérisé en ce que** ladite liaison de type mécanique s'effectue par aiguilletage, dans lequel des aiguilles à crochet (180, 180') traversent ladite couche de revêtement (9, 9') pour lier mécaniquement les fibres minérales de l'âme (113) entre elles et à la couche de revêtement (9, 9').

21. Procédé selon l'une quelconque des revendications 18 à 20, **caractérisé en ce qu'**il comprend l'étape d'addition d'agents anti-poussière aux fibres minérales avant l'étape de liaison mécanique.

22. Procédé selon l'une quelconque des revendications 12 à 21, **caractérisé en ce que** l'étape de filage des fibres minérales (10) à partir d'une substance minérale fondue est effectuée par un procédé rotatif par centrifugation interne.

23. Utilisation d'un panneau isolant selon l'une quelconque des revendications 1 à 11 pour le calorifugeage d'un appareil électrique notamment ménager, tel qu'un four de cuisine, électrique ou à micro-ondes, un réfrigérateur, une chaudière, un conditionneur ou climatiseur.

## Patentansprüche

1. Dämmpanel zur Wärmedämmung eines Elektrogeräts, wobei das Panel auf Mineralfasern basiert, die aus Glasfasern, Glaswolle oder Steinwolle ausgewählt sind, und einen Kern (13; 113) aus Mineralfasern umfasst, die durch ein mineralisches Bindemittel oder durch eine mechanische Verbindung miteinander verbunden sind, und eine Deckschicht (9, 9'), die auf mindestens eine Seite des Kerns aus Mineralfasern (13; 113) aufgebracht ist, **dadurch gekennzeichnet, dass** die Deckschicht (9; 9') einen Vliesstoff (TNT), ein Mineralfasergewebe oder eine Mineralfasermatte umfasst, dass die Deckschicht durch ein mineralisches Bindemittel mit den Mineralfasern des Kerns chemisch verbunden oder mit den Mineralfasern des Kerns mechanisch verbunden ist und dass die Deckschicht (9; 9') ein Flächengewicht im Bereich von 10 g/m² bis 100 g/m² aufweist.

2. Panel nach Anspruch 1, **dadurch gekennzeichnet, dass** die Deckschicht (9; 9') ein Glasfasergewebe oder -matte umfasst.

3. Panel nach Anspruch 1, **dadurch gekennzeichnet, dass** die Deckschicht (9; 9') einen Vliesstoff (TNT) aus synthetischen Polymerfasern umfasst, insbesondere bestehend aus Polyethylen- und Polyesterderivaten, denen gegebenenfalls Metalloxid-Füllstoffe zugegeben sind.

4. Panel nach einem der vorhergehenden Ansprüche, **dadurch gekennzeichnet, dass** die Deckschicht (9; 9') eine Dicke aufweist, die indikativ im Bereich von 0,05 mm bis 1,5 mm liegt.

5. Panel nach einem der vorhergehenden Ansprüche, **dadurch gekennzeichnet, dass** der Kern aus Mineralfasern eine flächenbezogene Masse in der Größenordnung von 600 bis 1000 g/m² aufweist.

6. Panel nach einem der vorhergehenden Ansprüche, **dadurch gekennzeichnet, dass** der Kern aus Mineralfasern Glasfasern mit einem Mikronaire in der Größenordnung von 3 bis 4,5 in 5 g umfasst.

7. Panel nach einem der vorhergehenden Ansprüche, **dadurch gekennzeichnet, dass** es chemische Bindemittel umfasst, um sowohl eine chemische Bindung zwischen den Mineralfasern des Kerns (13) als auch eine chemische Bindung zwischen der Deckschicht (9; 9') und den Mineralfasern des Kerns (13) zu ermöglichen.

8. Panel nach Anspruch 7, **dadurch gekennzeichnet, dass** das chemische Bindemittel ein mineralisches Bindemittel ist, das aus einer wässrigen Lösung von Aluminiumpolyphosphatsalzen besteht.

9. Panel nach einem der Ansprüche 1 bis 6, **dadurch gekennzeichnet, dass** die Mineralfasern des Kerns (113) mechanisch miteinander verbunden sind und dass die Deckschicht (9, 9') mit den Mineralfasern des Kerns (113) mechanisch verbunden ist.

10. Panel nach Anspruch 9, **dadurch gekennzeichnet, dass** die mechanische Verbindung durch Vernadelung der Mineralfasern miteinander und durch Vernadelung der Mineralfasern mit der Deckschicht (9, 9') erhalten wird.

11. Panel nach Anspruch 9 oder 10, **dadurch gekennzeichnet, dass** es ein Antistaubmittel zwischen den Mineralfasern des Kerns (113) umfasst.

12. Verfahren zur Herstellung eines Dämmpanels basierend auf Mineralfasern nach einem der Ansprüche 1 bis 8, das die folgenden Schritte umfasst:
- Spinnen der Mineralfasern (10) aus einer geschmolzenen Mineralsubstanz (1),
- chemisches Verbinden zwischen den Mineralfasern (10), um einen Kern aus miteinander chemisch verbundenen Mineralfasern (13; 113) zu erhalten,
- chemisches Verbinden des Kerns (13; 113) aus Mineralfasern mit einer Deckschicht (9, 9'), die auf mindestens einer Seite des Kerns (13; 113) aus Mineralfasern angeordnet ist.

13. Verfahren nach Anspruch 12, **dadurch gekennzeichnet, dass** die Phase des Verbindens der Mineralfasern (13; 113) miteinander gleichzeitig mit dem Schritt des Verbindens der Mineralfasern mit der Deckschicht (9, 9') unter Verwendung einer chemischen Verbindung stattfindet.

14. Verfahren nach den Ansprüchen 12 oder 13, **dadurch gekennzeichnet, dass** die Schritte des chemischen Verbindens die folgenden Phasen umfassen:
- Zugeben eines mineralischen Bindemittels zu den Mineralfasern (10),
- Aufnehmen der Mineralfasern (11) mit dem mineralischen Bindemittel auf einem Streifen der Deckschicht (9),
- Ansaugen von Luft durch die Deckschicht (9) und anschließendes Trocknen der mineralischen Bindemittel, um die Verbindung von Mineralfasern miteinander und die Verbindung der Mineralfasern mit der Deckschicht (9) herzustellen.

15. Verfahren nach Anspruch 14, **dadurch gekennzeichnet, dass** es ferner die Schritte umfasst, die bestehen aus:
- Abscheiden des mineralischen Bindemittels auf eine zweite Deckschicht (9') und
- Aufbringen der zweiten Deckschicht (9') auf die Oberfläche des Kerns (13) aus Mineralfasern, die derjenigen entgegengesetzt ist, mit der die erste Deckschicht (9) verbunden ist, sodass sich das mineralische Bindemittel zwischen der zweiten Deckschicht (9') und einer Seite des Kerns aus Mineralfasern (13) befindet.

16. Verfahren nach Anspruch 15, **dadurch gekennzeichnet, dass** es ferner den Schritt des Trocknens des zwischen der zweiten Deckschicht (9') und einer Oberfläche des Kerns aus Mineralfasern (13) abgeschiedenen mineralischen Bindemittels durch Erwärmen umfasst.

17. Verfahren nach Anspruch 16, **dadurch gekennzeichnet, dass** der Schritt des Trocknens des mineralischen Bindemittels durch Erwärmen bei einer Temperatur im Bereich von 100 °C bis 200 °C durchgeführt wird.

18. Verfahren zur Herstellung eines Dämmpanels basierend auf Mineralfasern nach einem der Ansprüche 9 bis 11, das die folgenden Schritte umfasst:
- Spinnen der Mineralfasern (10) aus einer geschmolzenen Mineralsubstanz (1),
- mechanisches Verbinden der Mineralfasern (10) miteinander, um einen Kern aus Mineralfasern (113) zu erhalten, die miteinander mechanisch verbunden sind,
- mechanisches Verbinden des Kerns (113) aus Mineralfasern mit einer Deckschicht (9, 9'), die auf mindestens einer Seite des Kerns (113) aus Mineralfasern angeordnet ist.

19. Verfahren nach Anspruch 18, **dadurch gekennzeichnet, dass** der Schritt des Verbindens von Mineralfasern (113) miteinander gleichzeitig mit dem Schritt des Verbindens der Mineralfasern mit der Deckschicht (9, 9') durch eine mechanische Verbindung erfolgt.

20. Verfahren nach den Ansprüchen 18 oder 19, **dadurch gekennzeichnet, dass** die mechanische Verbindung durch Vernadelung bewirkt wird, wobei Hakennadeln (180, 180') durch die Deckschicht (9, 9') verlaufen, um die Mineralfasern des Kerns (113) miteinander und mit der Deckschicht (9, 9') mechanisch zu verbinden.

21. Verfahren nach einem der Ansprüche 18 bis 20, **dadurch gekennzeichnet, dass** es den Schritt der Zugabe von Antistaubmitteln zu den Mineralfasern vor dem Schritt des mechanischen Verbindens umfasst.

22. Verfahren nach einem der Ansprüche 12 bis 21, **dadurch gekennzeichnet, dass** der Schritt des Spinnens der Mineralfasern (10) aus einer geschmolzenen mineralischen Substanz durch ein Rotationsverfahren durch interne Zentrifugation durchgeführt wird.

23. Verwendung eines Dämmpanels nach einem der Ansprüche 1 bis 11 zur Wärmedämmung eines Elektrogeräts, insbesondere eines Haushaltsgeräts, wie eines Herds, Elektro- oder Mikrowellenofens, eines Kühlschranks, eines Heizkessels, eines Klimageräts oder einer Klimaanlage.

## Claims

1. An insulating panel for lagging electrical equipment, the panel being based on mineral fibers selected from glass fibers, glass wool, rockwool, and comprising a core (13; 113) of mineral fibers interconnected by a mineral binder or a mechanical connection and a facing layer (9, 9') applied to at least one face of said core of mineral fibers (13; 113), **characterized in that** said facing layer (9; 9') comprises a woven-nonwoven (WNW), a woven mineral fiber fabric or a web of mineral fibers, and **in that** the facing layer is chemically bonded to the mineral fibers of the core by a mineral binder or is mechanically connected to the mineral fibers of the core and **in that** said facing layer (9; 9') has a weight lying in the range from 10 g/m² to 100 g/m².

2. The panel as claimed in claim 1, **characterized in that** said facing layer (9; 9') comprises a woven fabric or a web of glass fibers.

3. The panel as claimed in claim 1, **characterized in that** said facing layer (9; 9') comprises a woven-nonwoven (WNW) of polymer synthetic fibers, consisting in particular of derivatives of polyethylene and of polyester to which metal oxide fillers are possibly added.

4. The panel as claimed in any one of the preceding claims, **characterized in that** said facing layer (9; 9') has a thickness lying, by way of indication, in the range from 0.05 mm to 1.5 mm.

5. The panel as claimed in any one of the preceding claims, **characterized in that** the core of mineral fibers has a mass per weight area of the order of 600 to 1 000 g/m².

6. The panel as claimed in any one of the preceding claims, **characterized in that** the core of mineral fibers comprises glass fibers with a micronaire of the order of 3 to 4.5 under a load of 5 g.

7. The panel as claimed in any one of the preceding claims, **characterized in that** it comprises chemical binders in order both to form a chemical bond between the mineral fibers of the core (13) and to form a chemical bond between the facing layer (9; 9') and the mineral fibers of the core (13).

8. The panel as claimed in claim 8, **characterized in that** said chemical binder is a mineral binder consisting of an aqueous solution of aluminum polyphosphate salts.

9. The panel as claimed in any one of claims 1 to 6, **characterized in that** said mineral fibers of the core (113) are mechanically interconnected and **in that** said facing layer (9, 9') is mechanically connected to the mineral fibers of the core (113).

10. The panel as claimed in claim 9, **characterized in that** said mechanical connection is obtained by needle punching the mineral fibers together and by needle punching the mineral fibers to the facing layer (9, 9').

11. The panel as claimed in claim 9 or 10, **characterized in that** it comprises an anti-dust agent between the mineral fibers of the core (113).

12. A method for producing an insulating panel based on mineral fibers as claimed in any one of claims 1 to 8, and which comprises the following steps:
- spinning mineral fibers (10) from a molten mineral substance (1),
- producing a chemical-type bond between said mineral fibers (10) so as to obtain a core of chemically inter-bonded mineral fibers (13; 113),
- producing a chemical-type bond between said core of mineral fibers (13; 113) and a facing layer (9, 9') positioned on at least one face of said core of mineral fibers (13; 113).

13. The method as claimed in claim 12, **characterized in that** said phase of bonding the mineral fibers (13; 113) together takes place at the same time as the step of bonding the mineral fibers to the facing layer (9, 9') by recourse to a chemical-type bond.

14. The method as claimed in claims 12 or 13, **characterized in that** said steps of chemical-type bonding involve the following phases:
- adding a mineral binder to the mineral fibers (10),
- receiving the mineral fibers (11) together with the mineral binder on a strip of said facing layer (9),
- sucking air through said facing layer (9) and then drying said mineral binders in order to create the bond between the mineral fibers and the bond between the mineral fibers and the facing layer (9).

15. The method as claimed in claim 14, **characterized in that** it further comprises the steps consisting in:
- depositing the mineral binder on a second facing layer (9') and
- applying said second facing layer (9') onto the opposite surface of the core of mineral fibers (13) to the one to which said first facing layer (9) is bonded so that said mineral binder is located between said second facing layer (9') and one face of the core of mineral fibers (13).

16. The method as claimed in claim 15, **characterized in that** it further comprises the step of drying said mineral binder deposited between said second facing layer (9') and a surface of the core of mineral fibers (13), by heating.

17. The method as claimed in claim 16, **characterized in that** said step of drying the mineral binder by heating is performed at a temperature ranging between 100°C and 200°C.

18. A method for producing an insulating panel based on mineral fibers as claimed in any one of claims 9 to 11, which comprises the following steps:
- spinning mineral fibers (10) from a molten mineral substance (1),
- producing a mechanical-type connection between said mineral fibers (10) so as to obtain a core of mechanically interconnected mineral fibers (113),
- producing a mechanical-type connection between said core of mineral fibers (113) and a facing layer (9, 9') positioned on at least one face of said core of mineral fibers (113).

19. The method as claimed in claim 18, **characterized in that** said phase of bonding the mineral fibers (113) together takes place at the same time as the step of bonding the mineral fibers to the facing layer (9, 9') using a connection of a mechanical type.

20. The method as claimed in claims 18 or 19, **characterized in that** said connection of a mechanical type is achieved by needle punching, in which hooked needles (180, 180') pass through said facing layer (9, 9') to mechanically connect the mineral fibers of the core (113) to one another and to the facing layer (9, 9').

21. The method as claimed in any one of claims 18 to 20, **characterized in that** it comprises the step of adding anti-dust agents to the mineral fibers prior to the mechanical-connection step.

22. The method as claimed in any one of claims 12 to 21, **characterized in that** the step of spinning the mineral fibers (10) from a molten mineral substance is performed using a rotary process involving internal centrifugation.

23. The use of an insulating panel as claimed in any one of claims 1 to 11 for lagging electrical equipment, particularly household electrical equipment, such as an electric or microwave oven, a refrigerator, a boiler, or some form of air-conditioning equipment.
